# EUROPEAN PATENT APPLICATION

(11) **EP 1 641 029 A1**
(43) Date of publication of application: **29.03.2006**
(21) Application number: 04425715.2
(22) Date of filing: 27.09.2004
(51) Int. Cl.: H01L 21/04

(54) **Process for manufacturing a Schottky contact on a semiconductor substrate**

(71) Applicant: STMicroelectronics S.r.l., 20041 Agrate Brianza (Milano) (IT)
(72) Inventor: Roccaforte, Fabrizio, 95030 Mascalucia (Catania) (IT); Raineri, Vito, 95125 Catania (IT); La Via, Francesco, 95124 Catania (IT); Saggio, Mario, 95021 Aci Castello (Catania) (IT)
(74) Representative: Botti, Mario

(57) **Abstract**

Process for the realisation of a Schottky contact on an epitaxial layer of a semiconductor substrate (1), of the type comprising a deposition step (16) of a conductive metallic layer (18) on a surface of the epitaxial layer (32), with achievement of a interface region (20) of conductive metallic layer /semiconductor. The process further comprises a ionic irradiation step (22) directed towards the surface of the epitaxial layer (32) for forming a modified intermediate layer (26, 126) of at least one surface portion (15) of the epitaxial layer (32) for making the electric behaviour of the interface region (20) substantially dependant on the contact between the conductive metallic layer and the obtained modified intermediate layer (26, 126).

## Description

### Field of application

The present invention relates, in its more general aspect, to the realisation of integrated circuit elements, and in particular to a Schottky diode, of the type comprising a crystalline semiconductor substrate of the n type covered by an epitaxial layer, a Schottky contact, i.e. a junction between the epitaxial layer and the first conductive metallic layer, and a ohmic contact realised on a side of the substrate opposite to the epitaxial layer, between a semiconductor and a second conductive metallic layer.

In its even more particular aspect the present invention relates to a process for manufacturing a Schottky contact on a semiconductor substrate of the type comprising a deposition step of the conductive metallic layer on a surface of the epitaxial layer, with achievement of an interface region of conductive metallic layer/ semiconductor.

### Prior art

Several publications, such as K.J. Schoen, J.M. Woodall, J.A. Cooper, M.R. Melloch, IEEE Trans. on Electron Devices, 45, 1595 (1998); V. Saxena, J.N. Su, A.J. Steckl, *IEEE Trans. on Electron Devices* 46, 456 (1999)] and R. Weiss, L. Frey, H. Ryssel, Appl. Surf. Sci. 184, 413 (2001), describe methods for the realisation of a Schottky contact of the above mentioned type by using in the specific case different types of metals, among which the most important are Ni and Ti, besides Pt, Mo, Ta, W, etc. and SiC such as semiconductor.

Moreover, Schottky diodes for high voltages in SiC have been widely demonstrated in the literature for example in: Q. Wahab et al., Appl. Phys. Lett. 72, 445 (1998).

It is also known that the crucial need of the semiconductor devices, and in particular of the Schottky diodes of the above mentioned type, is that of ensuring a high reproducibility of the electric characteristics, which results in the possibility of obtaining contacts with a ideal factor near 1 and such a value of the so called barrier height Φ_{B} as to reduce the leakage current as much as possible, i.e. the in reverse-bias dispersion current.

In particular, as regards the Schottky diodes, the above mentioned electric properties depend, in a critical way, on the preparation process of the surface of the semiconductor epitaxial layer immediately prior to the deposition of the conductive metallic layer.

In particular, the presence of oxide residuals and of contamination deriving from the previous treating steps (the oxides are normally used for the protection of the semiconductor epitaxial layer prior to the deposition of the conductive metallic layer) determines, consequently, the formation of a high density of interface states, which implies the formation of non ideal electric characteristics.

In some cases, for overcoming this drawback, it is necessary to treat the conductive metallic layer/ semiconductor contacts so as to make the electrical characteristics independent from the preparation process of the surface of the epitaxial layer.

For example in the case of Schottky contacts in nickel it is possible to subject the system Ni/SiC to quick thermal processes in non oxidising atmosphere at temperatures non lower than 500-600°C. In this way a reaction is induced which determines the formation of nickel silicides whose electrical properties can be better than those of a pure contact in Ni (F. Roccaforte, F. La Via, V. Raineri, P. Musumeci, L. Calcagno, G.G. Condorelli, Appl. Phys. A, 77, 827 (2003)].

In this regard it has been noted that the formation of the nickel silicide implies the consumption of a surface layer of SiC and, exactly for this reason, the electrical characteristics of the contact are independent from the preparation method of the surface used before the deposition of the metallic contact. Typical values of the barrier height Φ_{B} of the nickel silicide (Ni₂Si) are 1.39 eV in 6H-SiC and 1.60 eV in 4H-SiC [F. Roccaforte, F. La Via, V. Raineri, R. Pierobon, E. Zanoni, J. Appl. Phys. 93, 9137 (2003)].

The just described procedure cannot be however easily applied for the realisation of contacts which interest other metals, such as for example the titanium, which do not react at temperatures reasonably low with the SiC forming silicide homogeneous layers.

In fact, these metals, and especially the titanium, provoke the formation of silicide homogeneous layers with the SiC at higher temperatures than the Ni, and an adequate preparation of the semiconductor surface is required prior to the deposition of the conductive metallic layer.

In fact, if the preparation process of the surface is not optimised, at high temperatures the contact is inhomogeneous and degrades, in such extent as not to ensure reproducible electric characteristics (the most common result of a non optimised process is the formation of a Schottky barrier non sufficiently high (for example lower than 1.1 eV in the case of the titanium) due to the pinning of the Fermi level [E.H. Rhoderick, R.H. Williams, Metal-Semiconductor contacts, Oxford Science Publications, Oxford, 1988) and moreover high reverse-bias leakage current values are obtained [D. Defives, O Noblanc, C. Dua, C. Brilinsky, M. Barthula, F. Meyer, Mat. Sci. Eng. B 61-62, 395 (1999)].

This drawback is even more disadvantageous for the titanium due to the fact that such metal particularly serves for the realisation of a Schottky contact thanks to its barrier height values Φ_{B} which are generally lower than those of a Schottky contact with Ni (0.70-0.90 eV in 6H-SiC and 1.20-1.25 in 4H-SiC [L. Porter, R.F. Davis, Mat. Sci. Eng. B 34, 83 (1995)) and that, therefore, allow obtaining some lower voltage drop values V_{F} in forward bias.

For improving the preparation of the semiconductor surface, in the literature several conventional cleaning treatments are reported, which use solvents or acids, to which subjecting the SiC surface immediately prior to depositing a generic Schottky contact.

As an alternative, for preparing the semiconductor surface the growth of a sacrificial thermal oxide layer has been proposed, obtained through thermal processes in oxygen at temperatures of about 1150°C, ad its removal through "in wet" chemical etchings immediately prior to depositing the contact [P. Dethard, P. Friedrichs, R. Schoener, German Patent n° WO0122474].

Another process for preparing the semiconductor surface provides the deposition of a graphite layer on the SiC surface, the covering of such layer with a conductive metallic layer which can react forming carbides (for example Ti, Ta, W, etc.) and induce the formation of a carbide layer through some thermal treatments [R. Rupp, US Patent n° 6,139,624].

Nevertheless, the just described surface treatments have the drawback, still unsolved, of not ensuring a control of the barrier height and of the leakage current, and the achievement in a reproducible way Ti/SiC contacts having ideal characteristics, which, as above mentioned, should have values of ΦB=1.20-1.25.

For avoiding this, it has also been proposed, independently from the preparation of the surface prior to the deposition of the conductive metallic layer, of treating the Schottky contacts at temperatures of 400-500°C in non oxidising atmospheres (vacuum, Ar, N₂, forming gas) so as to increase the Φ_{B} value up to the typical value of 1.20-1.25 eV, decreasing the leakage current, improving the ideality index and reducing the density of interface states.

This latter procedure has however the drawback that the thermal processes at these temperatures can induce the formation of inclusions of TiC and Ti₅Si₃ in the interface region Ti/SiC, provoking a inhomogeneous barrier [D. Defives, O Noblanc, C. Dua, C. Brilinsky, M. Barthula, F. Meyer, Mat. Sci. Eng. B 61-62, 395 (1999)].

Starting from the set of the above cited drawbacks, the technical problem underlying the present invention stays in devising a procedure for realising Schottky contacts which allows to control the height of the contact barrier Φ_{B} independently from the preparation procedure of the preparation procedure of the interface of conductive metallic layer/epitaxial layer, especially in the case of Schottky contacts formed of conductive metallic layers which do not react at temperatures reasonably low with SiC forming silicide homogeneous layers.

### Summary of the invention

The above technical problem is solved by a process for the realisation of a Schottky contact of the above mentioned type, which, according to the invention, comprises a ionic irradiation step directed towards the surface of the epitaxial layer so as to form a modified intermediate layer at least of a surface portion of the epitaxial layer for making the electric behaviour of the interface region substantially dependant on the contact between the conductive metallic layer and the obtained modified intermediate layer and consequently independent from the procedure for preparing the surface of the epitaxial layer.

In other words, the process according to the invention provides a ionic irradiation step on the surface portion of the epitaxial layer, i.e. exactly in an active area of the Schottky contact, so as to modify the structural and surface properties of this latter and so as to make the interface region independent from the preparation step of the epitaxial layer itself, this in order to improve the reproducibility of the electric characteristics.

The present invention also relates to a process for realising a Schottky diode according to claim 11.

Further characteristics and advantages of the process according to the invention will be apparent from the following description of an embodiment thereof given by way of indicative and non-limiting example with reference to the annexed drawings.

### Brief description of the drawings

Figures 1A-1D are respective schematic views of an operative sequence of the process according to the invention in accordance with a first embodiment;
Figures 2A-2D are respective schematic views of an operative sequence of the process according to the invention in accordance with a second embodiment;
Figures 3A-3F are respective schematic view of a method for realising a Schottky diode according to the sequence shown in figures 1A-1D;
Figures 4A and 4B show in two diagrams the current/potential rate in forward-, and respectively, reverse-bias of diodes realised by means of the process according to the invention.
Figure 5 shows a TRIM simulation relative to the interface region of the conductive metallic layer/ semiconductor of the Schottky diode obtained by the process according to the invention.
Figure 6 shows a TEM microscopy of a non-irradiated Ti/4H-SiC interface.
Figure 7 shows a TEM microscopy of the interface of figure 6 after irradiation.

### Detailed description

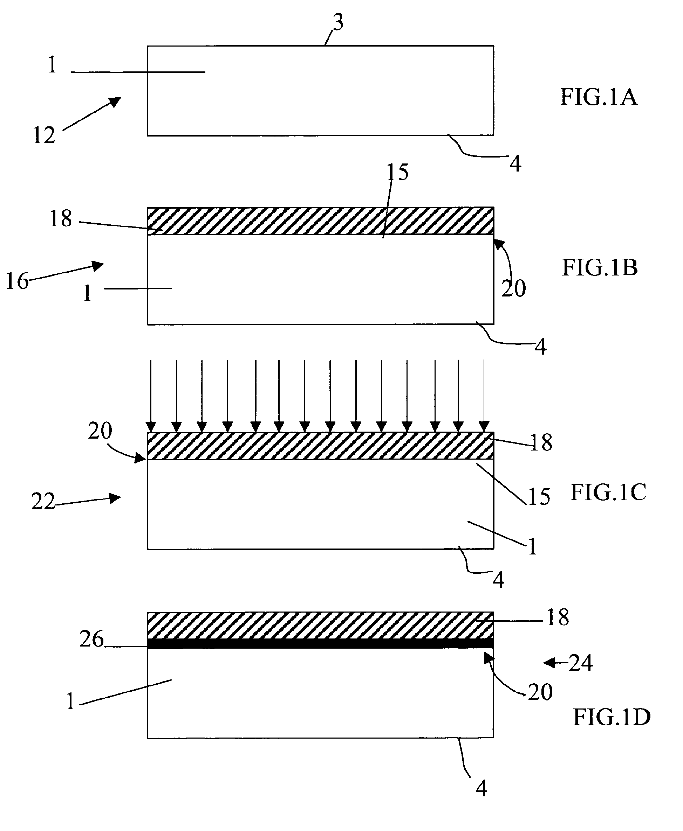

With reference to these figures, and in particular to the example of figure 1A-1D, 1 globally and schematically indicates a substrate of semiconductor material, for example monocrystalline silicon, subjected to a sequence of process steps provided by the method according to the present invention.

The process steps and the structures hereafter described are not a complete process flow for the manufacturing of integrated circuits. In fact, the present invention can be put into practice with the integrated circuit manufacturing techniques currently used in the field and hereafter only those commonly used process steps are described which are necessary for the comprehension of the invention.

The figures showing cross sections of a semiconductor wafer during the manufacturing are not drawn to scale, but they are instead drawn so as to show the important characteristics of the invention.

The substrate 1 is incorporated in the semiconductor wafer. This substrate can be with P+ doping or with N+ doping.

The wafer has a surface 3 which will be defined frontal, which is still row since only further it will be intended to house the topography of a device or of an electronic device monolithically integrated on the semiconductor.

The wafer 2 comprises a rearward surface 4, which is opposite to the frontal surface 3. Hereafter in the description the above frontal 3 and rearward 4 surfaces will be referred to also with the respective words front 3 and rear 4 of the wafer 2.

In the specific case the substrate 1 is provided on the front 3 with an epitaxial layer having thickness of some microns, not shown in the drawings, having doping lower than the substrate 1. In the particular case, a silicon carbide substrate is used having a very high doping of the n⁺ type (~10¹⁸ cm⁻³) and an epitaxial layer of lower doping ~10¹⁶ cm⁻³. The doper used is for example nitrogen.

In particular, in the embodiment of figure 1A, the process according to the invention provides a preparation step 12 of the substrate 1.

The preparation step 12 of the substrate 1 can occur according to any procedure known in the field for obtaining an active surface portion 15 of the epitaxial layer suitable for the formation of a Schottky contact.

In this regard, the process comprises a deposition step 16 (figure 1B) during which a metallic conductive layer 18, for example of titanium, is deposited on the active surface portion 15 of the epitacial layer with achievement of a interface region 20 of conductive metallic layer / semiconductor.

Also the deposition step 16 can be carried out according to any known above mentioned technology for the realisation of Schottky diodes.

In the specific case, a titanium layer of some hundreds of nanometres is deposited.

According to different further embodiments the process provide the use of metals Mo, Ta, Ni, Pt, or the like. According to the used metal further thermal treatment steps can be provided in controlled atmosphere according to the above mentioned procedures so as to reach an ideality index of the contact near 1.

According to the invention, the process comprises a further step 22 (figure 1C) during which an ion irradiation is carried out towards the active surface portion 15, passing through the conductive metallic layer 18.

In other words, according to the invention, the interface region 20 of the Schottky contact is subjected to a ionic irradiation, which involves in the specific case also the conductive metallic layer 18. The ions used for the ionic irradiation are for example Si, B, Al, C, or others having similar characteristics.

Preferably, the process according to the invention provides to calibrate the energy of the incising ions according to the thickness of the conductive metallic layer 18 to be crossed, so that the penetration depth of the incident ions reaches the interface region 20 of conductive metallic layer / SiC.

To this purpose, the energy of the ions varies from some tens to some hundreds of keV, in the case when a Schottky contact having thickness of some hundreds of nanometres is irradiated, to some MeV in the case when the irradiation is carried out through a complete layer having thickness of some microns.

The dose irradiated can vary in a wide range between 1×10⁸ and 1×10¹⁴ ions/cm², preferably in the range between 1×10⁹ and 1×10¹² ions/cm², but it must not however exceed the critical value required for the amorphisation of the SiC.

In order to limit the damage of the crystalline structure of the epitaxial layer, the irradiation can also be carried out by maintaining the sample at a temperature above the critical one for the amorphisation, and in particular in a range between 200 and 600°C.

As it is possible to note from the schematic illustration of figure 1D, the ionic irradiation determines in a terminal step 24 the formation of a modified intermediate layer 26 of the interface 20 conductive/semiconductor metallic layer, which, exactly die to the fact that the irradiation has crossed the conductive metallic layer, involves also the regions of the conductive metallic layer 18 external to the exact contact interface 20.

The importance of the intermediate and modified layer 26 in relation to the control of the barrier height substantially stays in that it results in a modification of the interface region 20 making it independent from the preparation step of the surface of the epitaxial layer prior to the deposition of the metallic conductive layer.

Further characteristics of the modified intermediate layer 26 will be better shown hereafter in the description with reference to an embodiment of the process for the realisation of a Schottky diode.

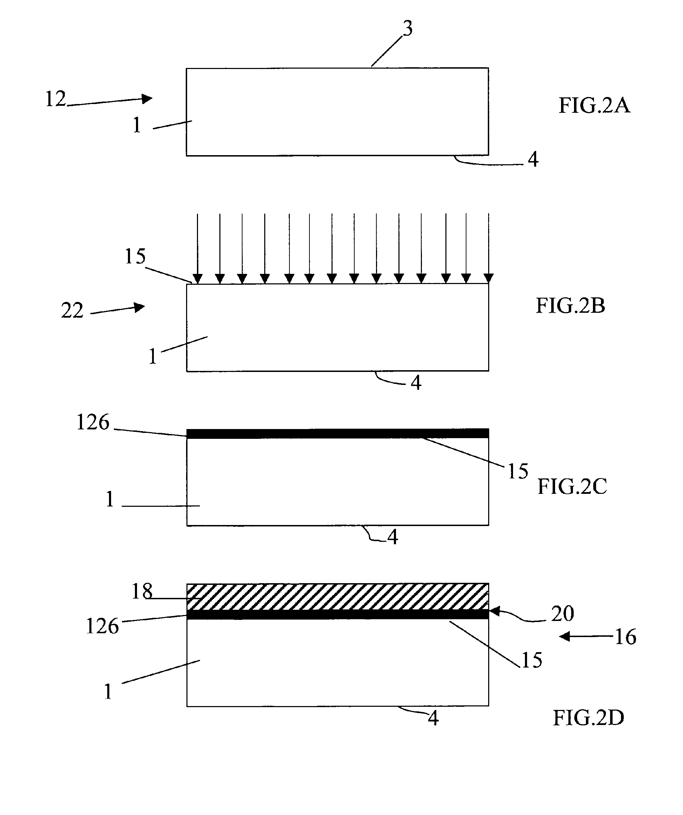

With reference to figures 2A-2D, another embodiment of the process according to the present invention is now described. In this figure, equal components and treatment steps having the same already described function, maintain equal reference numbers. These common components are thus not described again in detail.

As it can be noted from the figure, the process according to the invention provides the performance of the ionic irradiation prior to the deposition of the conductive metallic layer 18.

In particular, directly after the initial preparation step 12 of the above-described epitaxial layer (figure 2A); the ionic irradiation 22 is carried out (figure 2B). In this way the irradiation does not cross the conductive metallic layer 18, but only involves the active surface portion 15 of the epitaxial layer.

In this case, in order to reduce to the minimum the portion of epitaxial layer modified by the irradiation determined energy values are chosen, variable for example from some keV to some hundreds of keV.

As an alternative, it is possible to use a prospective "hard mask", such as for example SiO₂ or Si₃N₄. In this case, the implant energy will be determined according to the thickness of the "hard mask" itself. Subsequently as in the previous case the conductive metallic layer 18 is deposited (figure 2D).

In other words, differently from the above described embodiment, this embodiment, wherein the deposition of the conductive metallic layer 18 comes after the irradiation, determines the formation of a modified intermediate layer 126, which differently from the above described modified intermediate layer 26, only involves the contact surface portion 15 with the conductive metallic layer 18.

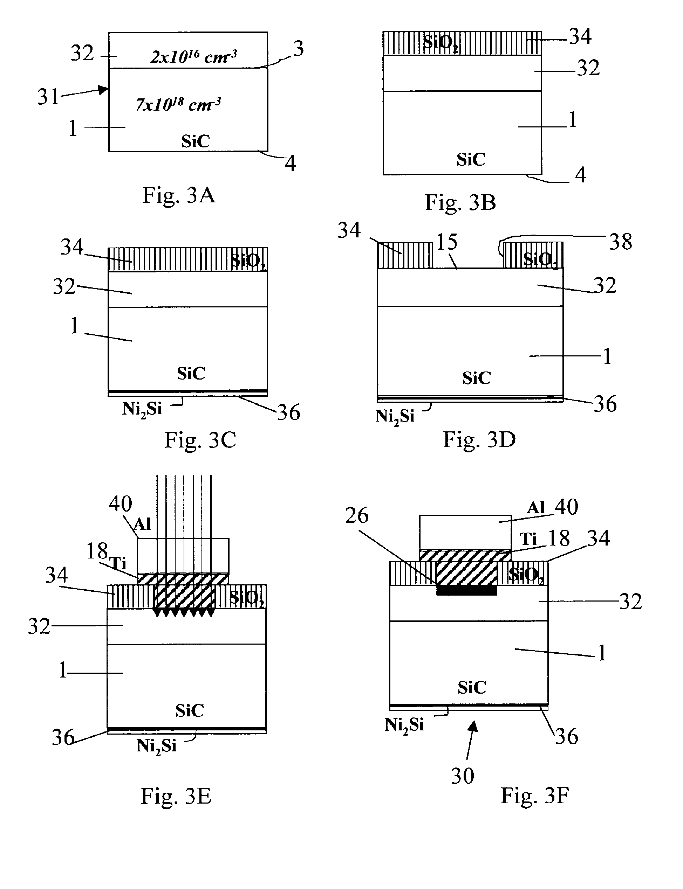

As above mentioned, for explaining in detail the modification effect of the material which is determined by the ionic irradiation on the interface region 20, a realisation sequence of a Schottky diode 30 as well as the analysis of the electric characteristics of this diode will be now described, with reference to figures 3A-3F and by way of example.

Also in this case, equal components and steps, having the same already described function, maintain equal reference numbers. These common components are thus not described again in detail.

In a first step (figure 3A) sample wafers 31 of 4H-SiC are prepared, comprising in particular the high doped substrate 1 of SiC of the n⁺ type (between 10¹⁸ and 10¹⁹, preferably about 7 × 10¹⁸ cm⁻³) whereon an epitaxial layer 32 has grown having thickness of some *µ*m, in the specific case 5 µm, less doped, about 2 × 10¹⁶ cm⁻³.

In a subsequent step (figure 3B), the front of the wafer 31 is protected with an oxide layer 34 having thickness of 1 µm, obtained through CVD (chemical vapor deposition).

On the rear 4 of the wafer 31, an ohmic contact is realised (figure 3C). This latter is obtained in a known way [J. Crofton, P.G. McMullin, J.R. Williams, M.J. Bozack, *J. Appl. Phys.* 77, 1317 (1995), F. Roccaforte, F.

La Via, V. Raineri, L. Calcagno, P. Musumeci, Appl. Surf. Sci. 184, 295 (2001) and F. Roccaforte, F. La Via, M. Saggio, Italian patent application n° VA 02A 0003] by depositing a film of Ni having thickness of 150 nm directly on the substrate 1 and by subjecting the sample to a quick thermal process in N₂ at 950°C for 60 seconds. The formation of a silicide layer is thus obtained (Ni₂Si) 36 with low values of contact specific resistance.

The active surface portion 15 of the wafer 31 is obtained by opening an opening 38 on the oxide layer 34 by means of an "wet" etching, for example according to the above mentioned method (figure 3D).

In a subsequent step, the Schottky contact is formed by depositing a titanium conductive layer 18 having thickness of some hundreds of nm, for example in the specific case 300 nm, in correspondence with the opening 38.

In a subsequent stage, on the titanium layer 18 a further layer of A1 40 is preferably deposited, typically having thickness of some µm, for example in the specific case 3,5 µm, for easily allowing the "bonding" of the diode.

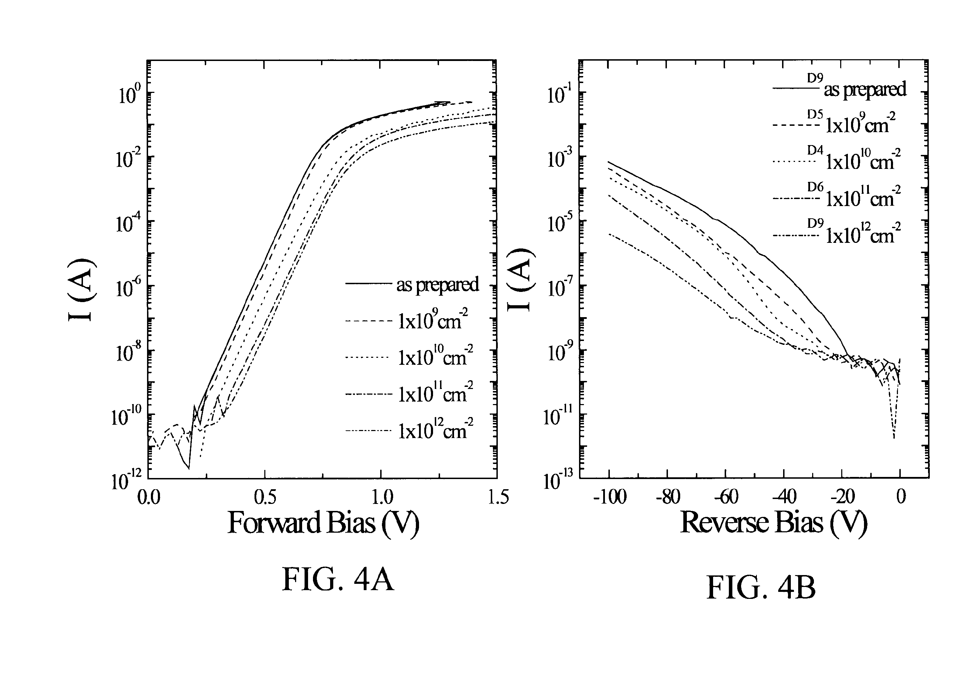

After the contact has been formed the thus obtained diode 30 is preferably subjected to a suitable thermal treatment at about 400-500°C in inert atmosphere, according to the above described known technology, for obtaining an ideality coefficient nearer to one and for increasing the Φ_{B} value. With reference to the diagrams of figure 4, the thus obtained diodes are defined "as prepared" diodes, with a Φ_{B} value of about 1.02-1.08eV, below the "theoretical" value of the barrier height of the titanium on 4H-SiC.

Subsequently, according to the invention, the diode 30, and in particular the active area thereof, is irradiated with Si ions, with doses comprised in the range 1×10⁹-1×10¹² ions/cm², so as to form the modified intermediate layer 26 (figure 3F).

The ionic irradiation energy is chosen in the range of the MeV, preferably 8 MeV, so that the greatest damage produced in the colliding cascade is located near the interface of Ti/SiC.

It is clear that a more accurate choice of the incident energy, such as of the temperature of the substrate during the irradiation, can allow to minimise the effects of the damage on the epitaxial SiC layer without however eliminating the effect of the energy deposition of the ionic beam on the Schottky contact.

Figures 4A and 4B show the voltage current electric characteristics (I-V) in forward-, and respectively, reverse-bias of the "as prepared" diodes, i.e. prior to the irradiation, and the diodes after the irradiation with the different doses with an irradiation of 8 MeV of Si with doses comprised in the above range 1×10⁹-1×10¹² ions/cm².

It is possible to note that, when the irradiation dose increases, the valued of the barrier height increases and the leakage current decreases. In particular, the Φ_{B} value passes from the above mentioned value of about 1.02-1.08eV in the "as prepared" diodes to about 1.20-1.22 eV after the irradiation with higher dose. In this way Ti/SiC contacts are obtained having substantially ideal characteristics.

It is also to be noted that no remarkable variations have been registered of the ideality index, which varied in the range 1.05-1.14 both prior to and after the irradiation process.

The leakage current results to be also reduced of a factor 100, passing from 6.5×10⁻⁴A to 3.5×10⁻⁶A at the voltage of 100 V.

It is to be noted that possible increases of series resistance Rₒₙ can be limited by optimising each time the parameters of the irradiated ion beam, such as ionic species, energy, dose, implant temperature and the like.

The result obtained by the process according to the invention can be explained from a physical point of view as follows.

One of the ionic irradiation effects in SiC in this range of doses is that of electrically deactivating the doper (in this case, nitrogen).

In the specific case, it is reasonable to think that the irradiation, by deactivating the nitrogen, creates a less doped region of the epitaxial layer 32 exactly near the interface 20, where the above mentioned modified intermediate layer 26, 126 is formed.

Therefore, the potential below the contact changes causing a Schottky barrier being wider than that of the non-irradiated contacts. As a consequence, a decrease of the tunnel thermal-ionic contribution to the leakage current is obtained, which is normally the predominant one.

A barrier with an emptied area being wider due to the deactivation of the doper near the interface 20 does not however completely justify the increased of the obtained Φ_{B} value according to the characteristics shown in figure 4.

This increase can instead be due to a decrease of the concentration of the interface states further to the irradiation, or to the presence of faults inside the gap which act as negatively charged acceptors provoking an increase of the potential barrier "seen" by the electrons.

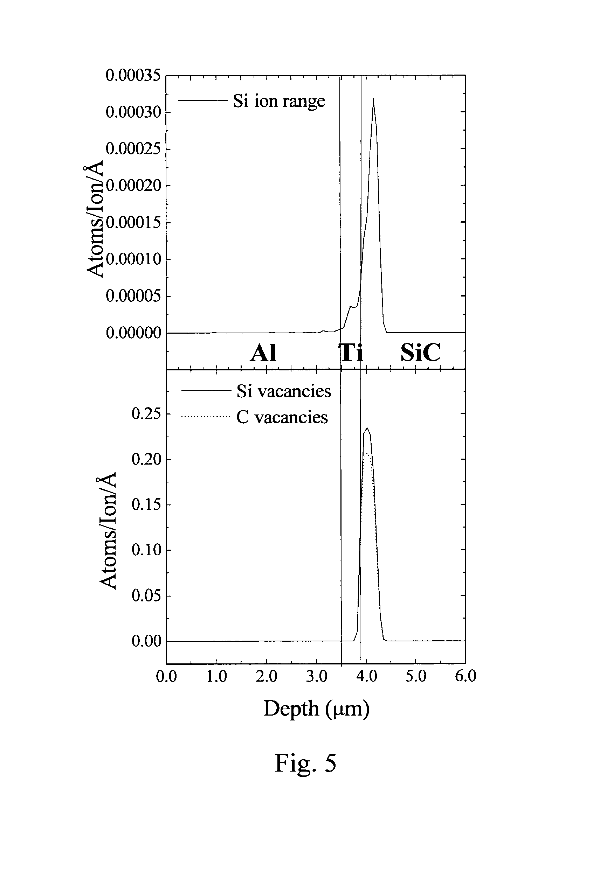

Figure 5 reports a TRIM simulation, in the case of an 8MeV Si ion implant on a metal/SiC contact, which shows this situation in the interface region 20.

In this example, the thickness of the metallic layer of Ti is of 300 nm and that of Al is of 3.5 µm. From the simulation it is evident how the distribution of the implanted ions as well as the presence of a defective region (this latter identifiable by the distribution of the silicon and carbon vacancy) are located near the Schottky contact in the irradiated sample, contrarily to the non-irradiated sample, where obviously no modified region is present near the contact.

Finally, it is not to be excluded that the observed variation of the Schottky barrier is due to a ion-beam mixing effect between Ti and SiC caused by the irradiation, with subsequent formation of bonds Ti-C at the interface 20.

The main advantage of the present invention is that the ionic irradiation, direct towards the epitaxial layer of the semiconductor, allows to obtain a greater control of the potential of Schottky barrier, with an effective improvement of the reproducibility of the electric characteristics and, overcoming the critical steps of the known processes due to the dependence on the typology of preparation of the epitaxial surface on the thermal treatments carried out.

Another advantage stays in that the irradiation step does not require to modify normal treating steps of Schottky diodes thanks to the fact that it can be inserted in the treatment sequence prior to or after the deposition step of the conductive metallic layer.

Another advantage of the method according to the present invention stays in that the ionic irradiation has a high application versatility, thanks to the possibility of varying the ionic energy, the dose and the employed ionic species, so as to optimise the irradiation process.

Moreover, the irradiation allows to locally vary the concentration of doper in the interface region, to limit the growth of series resistance Rₒₙ and to minimise the leakage current.

For adjusting the irradiation parameters, besides the above mentioned TRIM simulation, consolidated techniques can be employed such as the transmission electronic microscopy (TEM) or the capacitive scanner microsopy (SCM), i.e. techniques which allow a crossed control of the structural and electrical properties of the material in a quicker way and more precisely.

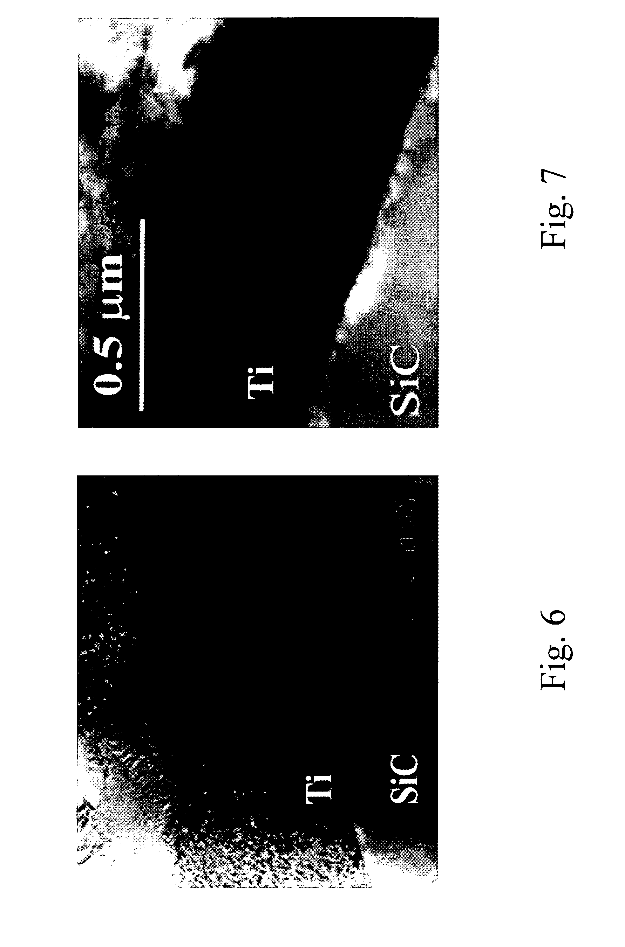

A TEM analysis in fact allows to show the presence of extended deficiencies due to an irradiation, with high doses. For example figures 6 and 7 show two TEM images relative to the non-irradiated Ti/4H-SiC contact and respectively to the contact irradiated with 8 MeV of Si with the dose of 1×10¹² ions/cm² following the process according to the first embodiment.

With the lowest irradiation doses (1×10⁹-1×10¹⁰ ions/cm²) an electric characterisation through SCM allows to have more detailed information on the active concentration of doper below the interface. Since the value of such concentration decreases further to the irradiation (deactivation of the doper), thus technique allows to electrically single out the modified intermediate layer and, therefore, an adjustment of the irradiation parameters.

For example, a measurement SCM carried out as test on the irradiated sample with the dose of 1×10⁹ ions/cm² has shown the presence of a layer having thickness of about 70 nm (according to the modified thickness measured by the TEM analysis) below the interface Ti/SiC with doper concentration of 1×10¹⁶ cm⁻³, lower than the nominal value of 2.4×10¹⁶ cm⁻³ of the epitaxial layer.

## Claims

1. Process for the realisation of a Schottky contact on an epitaxial layer of a semiconductor substrate (1), of the type comprising a deposition step (16) of a conductive metallic layer (18) on a surface of the epitaxial layer (32), with achievement of a interface region (20) of conductive metallic layer/semiconductor; **characterised in that** it comprises a further ionic irradiation step (22) directed towards the surface of the epitaxial layer (32) for forming a modified intermediate layer (26, 126) of at least one surface portion (15) of the epitaxial layer (32) for making the electric behaviour of the interface region (20) substantially dependant on the contact between the conductive metallic layer and the obtained modified intermediate layer (26, 126).

2. Process according to claim 1, **characterised in that** the ionic irradiation step is carried out after the deposition step of the conductive metallic layer (18), irradiating through the conductive metallic layer (18), so that the modified intermediate layer (26) involves both the interface region (20) between the epitaxial layer (32) and the conductive metallic layer (18) and the conductive metallic layer (18) external to the interface region (20).

3. Process according to claim 1, **characterised in that** the ionic irradiation step is carried out prior to the deposition step of the conductive metallic layer (18), irradiating only the epitaxial layer (32) so that the modified intermediate layer (126) is limited to the sole surface portion (15).

4. Process according to claim 2, **characterised in that** the irradiation energy of the incising ions is chosen according to the thickness of the conductive metallic layer (18) to be crossed, so that the penetration depth of the incident ions reaches the interface region (20) of conductive metallic layer/ semiconductor.

5. Process according to claim 2, **characterised in that** the irradiation energy of the incident ions is equal to a value comprised between some tens and some hundreds of keV, in the case when a conductive metallic layer (18) of a thickness of some hundreds of nanometres is irradiated.

6. Process according to claim 2, **characterised in that** the irradiation energy of the incident ions is equal to about some MeV in the case when the irradiation is carried out through a conductive metallic layer (18) having thickness of some microns.

7. Process according to claim 3, **characterised in that** the energy values of the irradiation directly on the epitaxial layer (32) are comprised in the range between some keV and some hundreds of keV.

8. Process according to claim 3, **characterised in that** it provides the epitaxial layer (32) with "hard mask", such as SiO₂ or Si₃N₄, so as to limit the damaged thickness of the surface epitaxial layer (32).

9. Process according to claim 8, **characterised in that** the implant energy is chosen according to the thickness of the "hard mask" itself.

10. Process according to claim 1, **characterised in that** the dose of irradiated ions is comprised between 1×10⁸ and 1×10¹⁴ ions/cm².

11. Process according to claim 10, **characterised in that** the dose of ions is comprised in the range between 1×10⁹ and 1×10¹² ions/cm².

12. Process according to claim 1, **characterised in that** the conductive metallic layer is titanium, and **in that** a dose of irradiated ions of 1×10¹² ions/cm² is employed.

13. Process according to claim 1, **characterised in that** during the irradiation step the substrate is maintained at a temperature above the critical one for the amorphisation thereof.

14. Process according to claim 13, **characterised in that** the temperature is comprised in the range between 200 °C and 600 °C.

15. Process for the realisation of a Schottky contact on a semiconductor substrate (1), of the type comprising the steps of
- formation of an epitaxial layer (32) on the substrate (1),
- deposition of a conductive metallic layer (18) on a surface of the epitaxial layer (32) with achievement of a interface region (20) of conductive metallic layer (18)/semiconductor (1),
- thermal treatment of the interface region (20) for obtaining an ideality coefficient nearer to 1 and a first increase of the barrier value (Φ_{B});
**characterised in that** it comprises an irradiation step of ions (22) directed towards the interface region (20) so as to form a modified intermediate layer (26, 126) (32) and to determine a second increase of the value of contact barrier height Φ_{B}) between the conductive metallic layer (18) and the epitaxial layer (32).

16. Process according to claim 15, **characterised in that** the conductive metallic layer (18) is titanium.

17. Process according to claim 16, **characterised in that** Si ions are irradiated in doses comprised in the range 1×10⁹-1×10¹² ions/ cm².

18. Process according to claim 16, **characterised in that** an irradiation energy is employed of 8 MeV of ions Si in doses of about 1×10¹² ions/cm² and **in that** the titanium layer (18) is equal to some hundreds of nm, so as to obtain a value of barrier height equal to 1.20-1.22 eV.
